# EUROPEAN PATENT APPLICATION

(11) **EP 1 076 120 A1**
(43) Date of publication of application: **14.02.2001**
(21) Application number: 00905294.5
(22) Date of filing: 23.02.2000
(51) Int. Cl.: C30B 29/06

(54) **METHOD FOR PRODUCING SILICON SINGLE CRYSTAL**

(30) Priority: 26.02.1999 JP 5178299
(71) Applicant: Shin-Etsu Handotai Co., Ltd, Tokyo 100-0005 (JP)
(72) Inventor: ISHIZUKA, Tohru, Shin-Etsu Handotai Co.,Ltd., Nishishirakawa-gun, Fukushima 961-8061 (JP); MIYAHARA, Yuuichi, Shin-Etsu Handotai Co., Ltd., Takefu-shi, Fukui 915-8525 (JP); FUSEGAWA, Izumi, Shin-Etsu Handotai Co., Ltd., Nishishirakawa-gun, Fukushima 961-8061 (JP); OHTA, Tomohiko, Shin-Etsu Handotai Co., Ltd., Nishishirakawa-gun, Fukushima 961-8061 (JP)
(74) Representative: Wibbelmann, Jobst, Dr., Dipl.-Chem.
(86) International application number: JP0001037
(87) International publication number: WO0052235

(57) **Abstract**

A method for producing silicon single crystals comprising pulling and growing single crystal ingots by the Czochralski method with applying a magnetic field, wherein a period for which silicon single crystals are produced by using a single quartz crucible is 100 hours or more, and strength of horizontal component magnetic field in a horizontal component magnetic field distribution or cusp type magnetic field distribution to be applied is 500 Gausses or more at a position where a silicon melt surface perpendicularly intersects with a side wall of the quartz crucible. According to the present invention, there can be provided a method for producing silicon single crystals, which can suppress degradation of the quartz crucible inner surface, and thereby realize prolonged lifetime of the quartz crucible, prevention of introduction of dislocations generated with the degradation of the crucible, reduction of the number of crucible per single crystal ingot to be pulled, reduction of the time required for the exchange of the crucible, improvement of yield and productivity, and industrial production of silicon single crystals of high quality at low cost.

## Description

### Technical Field

The present invention relates to MCZ method (Magnetic Field Applied Czochralski Method), wherein a silicon single crystal is pulled from a silicon melt contained in a crucible of a pulling apparatus by Czochralski Method (CZ method) while a magnetic field is applied to the silicon melt. More precisely, the present invention relates to a method for producing silicon single crystals while preventing degradation of an inner surface of quartz crucible used for the production of silicon single crystals by the MCZ method.

### Background Art

Silicon single crystal wafers used for the production of semiconductor devices are manufactured by the CZ method, which is effective mainly for the production of such wafers with a larger diameter. In recent years, production of silicon single crystals with a further larger diameter is required in order to respond to the use of a larger chip size as the integration degree of devices becomes higher (NIKKEI MICRODEVICES 1992, 11).

In the production of silicon single crystals by the CZ method, polycrystal silicon charged in a quartz crucible is melted and silicon single crystals are produced from the melt. Therefore, the inner surface of the quartz crucible is exposed to the silicon melt of a high temperature. As a result, a substance called cristobalite is formed on the inner surface of the crucible, which is hardly soluble in the silicon melt. This substance is peeled off from the inner surface of the quartz crucible during the growth of silicon single crystals and released into the silicon melt. If the exfoliated hardly soluble substance is adhered to the growing interface of a growing silicon single crystal, dislocations are introduced so that the thermal strain and so forth should be relaxed, and thus it constitutes a cause of dislocation generation of crystal.

For this reason, in the multi-pulling method where plurality of silicon single crystal ingots are continuously produced from the same quartz crucible by recharging raw material silicon polycrystal (Fumio Shimura, Semiconductor Silicon Crystal Technology, pp.178-179, 1989) and the like, the number of obtainable silicon single crystal ingots is limited by the lifetime of the quartz crucible.

Further, as disclosed in Japanese Patent Laid-open Publication (Kokai) No. 6-56588, for example, there has recently been disclosed a method for improving quality of silicon single crystals wherein growth rate during the production of a silicon single crystal is reduced to 0.8 mm/min or lower from the conventional growth rate of 1.0 mm/min in order to reduce grown-in defects in the silicon single crystal. However, the production time is prolonged due to the lower growth rate of the silicon single crystal, and therefore the degradation of the quartz crucible inner surface is accelerated. This causes problems, for example, troubles of dislocations are likely to occur, yield of the crystals is degraded, and the production cost becomes higher.

Further, as for suppression of the degradation of quartz crucible inner surface in the MCZ method, it has been suggested that, if the convection of the silicon melt in the quartz crucible is suppressed by applying a horizontal magnetic field, the melt comes to be unlikely to dissolve and corrode the quartz crucible and thus the lifetime of the crucible is prolonged, as disclosed in Japanese Patent Laid-open Publication No. 8-333191, for example. However, specific conditions therefor and so forth have not been described.

Furthermore, as for the cusp type MCZ method, there has been described only the use of weaker magnetic field strength for the silicon melt and the crystal growth interface, as disclosed in Japanese Patent Laid-open Publication No. 3-505442, for example.

### Disclosure of the Invention

Therefore, the present invention was accomplished in view of the aforementioned problems of the conventional techniques, and an object of the present invention is to provide a method for producing silicon single crystals by the CZ method where a magnetic field is applied to the melt, which enables the industrial production of silicon single crystals with a low cost by prolonging the lifetime of quartz crucible so as to increase the number of single crystals that can be pulled from a single quartz crucible in the multi-pulling method, thereby reducing unit consumption of the quartz crucible and the time required for the exchange of the quartz crucible. Further, it is also an object of the present invention to provide a method for efficiently producing silicon single crystals of high quality by prolonging lifetime of the quartz crucible in production of silicon single crystals of high quality with a low growth rate.

In order to solve the aforementioned problems, the present invention provides a method for producing silicon single crystals comprising pulling and growing single crystal ingots by the Czochralski method with applying a magnetic field, wherein a period for which silicon single crystals are produced by using a single quartz crucible is 100 hours or more.

If a magnetic field is applied to the silicon melt in the quartz crucible by the MCZ method as described above, degradation of the inner surface of the quartz crucible will be markedly suppressed. Therefore, the lifetime of the quartz crucible is prolonged, and the time for which the production of silicon single crystals can be performed with the quartz crucible can be stabilized to be a long period of time of 100 hours or more. Thus, silicon single crystals with dislocation are hardly produced. As a result, yield and productivity of dislocation-free silicon single crystals can be improved and the cost can be markedly improved at the same time.

In the aforementioned method, the applied magnetic field can form a horizontal magnetic field distribution with respect to the silicon melt in the crucible by bilaterally providing electromagnets in the right and left sides of a pulling apparatus.

If a horizontal magnetic field is applied to the silicon melt in the crucible as described above, the convection of the melt will be suppressed, and the power of corroding the inner surface of the quartz crucible will be reduced. Thus, the advance of degradation will be suppressed. Therefore, there can be prevented the degradation of the operability, for example, polycrystal growth due to generation of dislocations, which may be caused by disturbance of the single crystals due to the adhesion of the exfoliated hardly soluble substance originated from degraded quartz to the single crystals. Moreover, since the lifetime of the quartz crucible is markedly improved, the frequency of exchange of the quartz crucible can be reduced. Therefore, the unit consumption of the quartz crucible per single crystal ingot can be reduced, and thus the cost can be reduced.

Furthermore, as for the effect for preventing the degradation of quartz crucible, a cusp type magnetic field distribution can be formed with respect to the silicon melt in the crucible by providing electromagnets in the upper and lower sides around a pulling apparatus.

The effect for preventing the degradation of the inner surface of quartz crucible is attained also by a cusp type magnetic field to a degree comparable to that obtained by a horizontal magnetic field. Thus, yield and productivity of dislocation-free silicon single crystals can be improved, and the cost can be significantly improved.

In the method of the present invention, it is desirable that horizontal component magnetic field strength in the horizontal magnetic field distribution or the cusp type magnetic field distribution should be 500 Gausses (also abbreviated as G hereafter) or more at a position where the silicon melt surface perpendicularly intersects with the side wall of the quartz crucible.

As described above, in the both cases of applying a horizontal magnetic field and applying a cusp type magnetic field, it is desirable that the strength of the respective horizontal component magnetic field should be 500 Gausses or more at a position where the silicon melt surface perpendicularly intersects with the side wall of the quartz crucible. Such strength can surely prevent the advance of the degradation of the quartz crucible inner surface, and thus the lifetime of the quartz crucible can be stabilized to be a long period of time, i.e., 100 hours or more.

In the method for producing silicon single crystal according to the present invention, the pulling rate can be selected to be 0.2-0.8 mm/min.

According to the present invention, the desired effect can be attained with a usual pulling rate of around 1 mm/min. However, even if single crystals are produced with a low pulling rate controlled to be 0.2-0.8 mm/min as mentioned above, the degradation of the inner surface of the quartz crucible is suppressed by the aforementioned appropriate horizontal component strength of the magnetic field to be applied, and thus the operation time can be prolonged. Therefore, the number of obtainable dislocation-free silicon single crystal ingots per crucible is improved. Thus, the productivity is markedly improved, and silicon single crystals with an extremely low defect density over an entire crystal plane and improved oxide dielectric breakdown voltage characteristic can be produced.

If silicon single crystal ingots are pulled by the CZ method according to the present invention wherein a horizontal magnetic field or a cusp type magnetic field is applied with an appropriate horizontal component strength of magnetic field, which enables an operation time of 100 hours or more with a single quartz crucible, the degradation of the inner surface of quartz crucible hardly advances, and the lifetime of the crucible is stabilized to be a long period of time. Therefore, a plurality of single crystal ingots can be continuously produced without introducing dislocations. Thus, the productivity and the yield can be improved, and the cost can be markedly reduced.

Furthermore, even when the production is performed with a pulling rate controlled to be within a low pulling rate range of 0.2-0.8 mm/min, the degradation of the, inner surface of the quartz crucible is suppressed by the aforementioned appropriate horizontal component strength of the magnetic field to be applied, and thus the lifetime of the crucible can be prolonged. Therefore, the number of obtainable dislocation-free silicon single crystal ingots per crucible is improved. Thus, the productivity is markedly improved, and silicon single crystals with an extremely low defect density over an entire crystal plane and improved oxide dielectric breakdown voltage can be produced.

### Brief Explanation of the Drawings

Fig. 1 is a schematic view showing a structure of principal part of an apparatus for producing single crystals used for the present invention, which is provided with a cusp type magnetic field applying apparatus.
Fig. 2 is a view showing degradation of an inner surface of quartz crucible after production of silicon single crystals for a case where a cusp type magnetic field was applied (a), and a case where no magnetic field was applied (b).
Fig. 3 is a view showing relationship between degradation degree of an inner surface of quartz crucible and horizontal component magnetic field strength.
Fig. 4 is a view showing relationship between degradation degree of an inner surface of quartz crucible and period of production of silicon single crystals.

### Best Mode for Carrying out the Invention

Hereafter, embodiments of the present invention will be explained. However, the present invention is not limited to these.

The inventors of the present invention researched and examined the phenomenon observed in the growth of silicon single crystals by the CZ method that the inner surface of quartz crucible is corroded with the silicon melt of high temperature to form cristobalite, and peeled off cristobalite adheres to single crystal surfaces to generate dislocations, which suppresses the number of obtainable dislocation-free crystals. As a result, they found that kind and strength of magnetic field applied to the silicon melt surface might greatly influence on this phenomenon when the MCZ method was used. Then, they examined the detail of such influence, and thus accomplished the present invention.

### (Test 1)

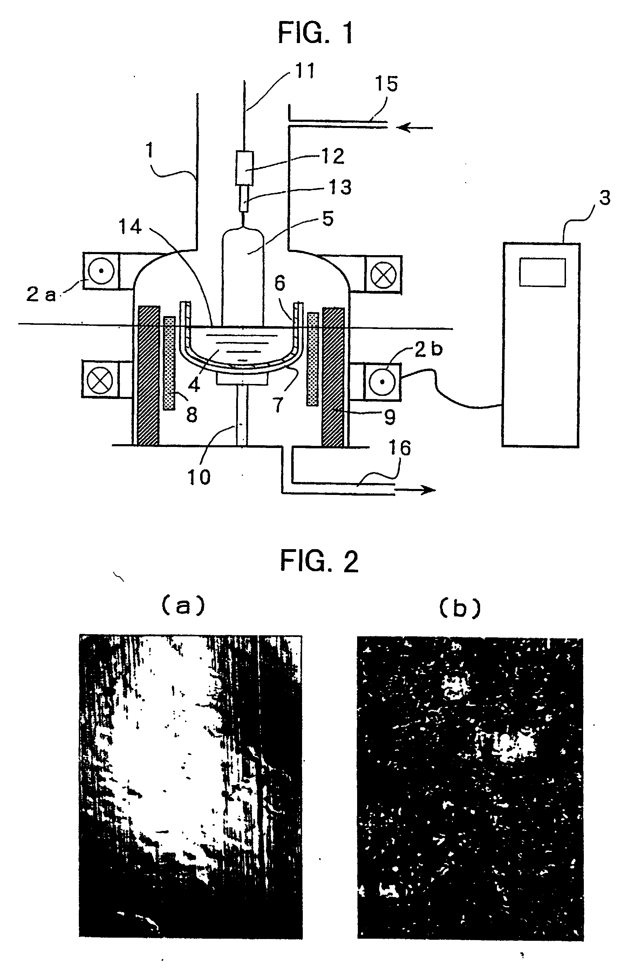

First, a plurality of single crystal ingots were pulled by the multi-pulling method using an apparatus for producing silicon single crystals provided with a cusp type magnetic field applying apparatus shown in Fig. 1, and condition of an inner surface of quartz crucible was observed.

Silicon polycrystal in an amount of 150 kg was charged into a quartz crucible having a diameter of 24 inches (610 mm) and heated to form a silicon melt. Then, the horizontal component magnetic field strength of a cusp type magnetic field was controlled to be 1500 G at a position where the silicon melt surface perpendicularly intersected with the side wall of the quartz crucible from the control panel of the magnetic field applying apparatus. As an inert gas, Ar was introduced at a rate of 100 L/min. A seed crystal was immersed in the silicon melt, and a silicon single crystal having a diameter of 200 mm was grown after necking. After the produced crystal ingot was taken out, the raw material polycrystal in the same amount as the pulled single crystal was charged in the quartz crucible, and a single crystal was pulled. The growth of single crystal was repeated, so that four single crystal ingots were pulled from the same quartz crucible.

In Fig. 2(a), there is shown the inner surface condition of the quartz crucible after the silicon single crystals were produced with applying a cusp type magnetic field as described above. In Fig. 2(b), there is shown the inner surface condition of a quartz crucible after one silicon single crystal ingot was pulled under the same condition as above except that no magnetic field was applied.

Fig. 2(a) shows that the inner surface of the quartz crucible is smooth and the degradation was suppressed, in spite of the production of the four silicon single crystals. On the other hand, Fig. 2(b) shows that the inner surface of the quartz crucible has significant unevenness, and the degradation was advanced although only one single crystal was produced.

### (Test 2)

Then, the influence of horizontal component magnetic field strength on the degradation of the inner surface of the quartz crucible was investigated.

The areas of the smooth part and the uneven part per unit area of the inner surface of the quartz crucible were measured, and a ratio of the uneven part was calculated as a degradation degree, and used as an index. For example, if a half of the measured area consists of the uneven part, the degradation degree is 50%.

Single crystals were produced with a horizontal component magnetic field strength within the range of 0-6000 G at a position where the silicon melt surface perpendicularly intersected with the side wall of the quartz crucible. When a horizontal magnetic field was applied, the strength of 180-6000 G was used, and when a cusp type magnetic field was applied, the strength of 300-1500 G was used.

Single crystals were produced under the same conditions as Test 1 except that the horizontal component magnetic field strength was controlled as described above, and the operation was performed for a constant period of 100 hours, and degradation degree of the inner surface of the quartz crucible after the operation was evaluated.

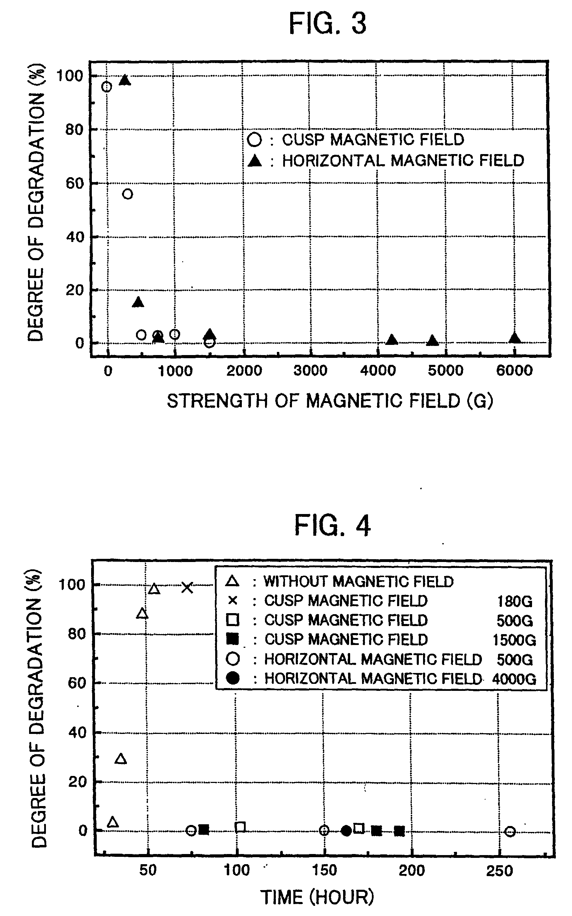

The results of the evaluation were shown in Fig. 3. From the results shown in Fig. 3, it can be seen that, when the standard of the degradation degree of the inner surface of the quartz crucible was defined to be 10% or less, the strength of the magnetic field should be 500 G or more for both of the horizontal magnetic field and the cusp type magnetic field.

From this result, it was found that the range of the horizontal component magnetic field strength that provided a small degradation degree of the quartz crucible, i.e., long lifetime of the quartz crucible, was 500 G or more.

### (Test 3)

Then, the influence of the operation time on the degradation degree of the inner surface of the quartz crucible was investigated.

A single crystal production test was performed with a horizontal component magnetic field strength of 0-4000 G at a position where the silicon melt surface perpendicularly intersected with the side wall of the quartz crucible. Single crystals were produced under the same conditions as Test 1 except that when a horizontal magnetic field was applied, the test was performed for a single crystal production time of 75-250 hours, and when a cusp type magnetic field was applied, the test was performed for a single crystal production time of 70-200 hours. Then, the degradation degree of the inner surface of the quartz crucible after the operation was evaluated.

The results of the evaluation are shown in Fig. 4. The results of Fig. 4 show that, even when a magnetic field was not applied, the degradation degree of the inner surface of the quartz crucible was 30% or less within an operation time of 50 hours or less, whereas the degradation rapidly advanced when the operation time exceeded 50 hours, and it became difficult to produce single crystals. On the other hand, when a horizontal magnetic field or a cusp type magnetic field was applied, a stable degradation degree of 10% or less for the inner surface of the quartz crucible was obtained under the condition of a horizontal component magnetic field strength of 500 G or more, and degradation was not observed even if the operation time was prolonged up to 180 hours. Therefore, it was found that, even if the production time was prolonged up to 100 hours or more, the degradation of the inner surface of the quartz crucible was not caused if a horizontal component magnetic field strength was 500 G or more at a position where the silicon melt surface perpendicularly intersected with the side wall of the quartz crucible.

### (Test 4)

Silicon single crystals having a diameter of 200 mm were produced by the multi-pulling method using an apparatus for producing silicon single crystals provided with an apparatus for applying a cusp type magnetic field, in which 150 kg of polycrystal was charged in a quartz crucible having a diameter of 24 inches. The production was performed with a growth rate of 1.0 m/min for a portion having a usual constant diameter and with four levels of magnetic field strength, i.e., without magnetic field, 300 G, 500 G and 1500 G. With a horizontal component magnetic field strength of 1500 G, the production test was also performed with a low growth rate of 0.4 mm/min for a portion having a constant diameter, which made the production time longer.

The results of the silicon single crystal production test are shown in Table 1.

The results of Table 1 show that the number of obtainable dislocation-free silicon single crystal ingots was improved and the productivity was markedly improved when the horizontal component magnetic field strength was 500 G or more. Further, also in the production with the low growth rate, which made the production time longer, the number of obtainable dislocation-free silicon single crystal was improved, and thus the effectiveness of the present invention could be confirmed.

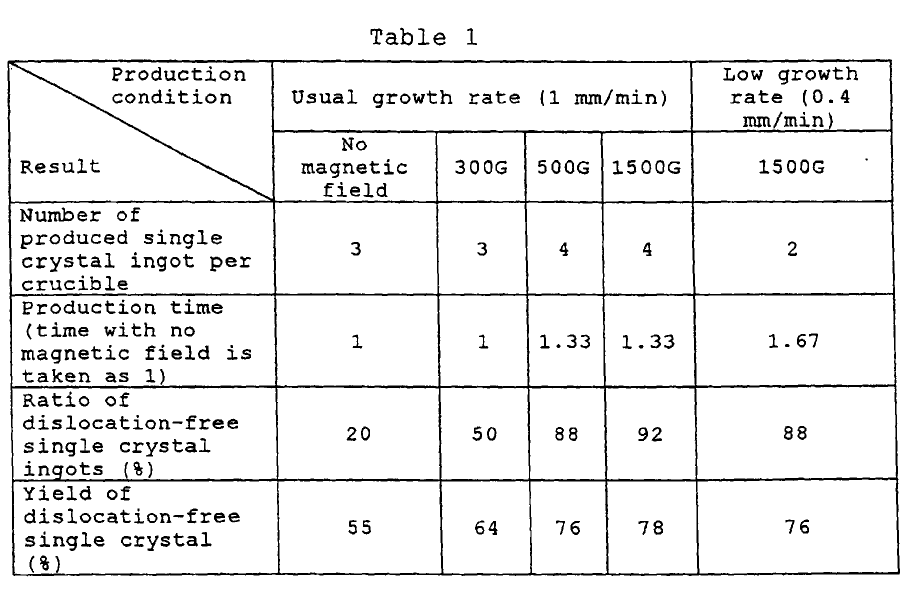

As explained above, the characteristic of the method for producing silicon single crystals of the present invention based on the CZ method, in which single crystal ingots are grown with applying a horizontal magnetic field or a cusp type magnetic field, is that, if a horizontal component magnetic field strength of 500 G or more in the horizontal magnetic field distribution or the cusp type magnetic field distribution is used at a position where the silicon melt surface perpendicularly intersects with the side wall of the quartz crucible, advance of the degradation of the quartz crucible inner surface is suppressed, and thus the lifetime of the quartz crucible becomes even 100 hours or more. Also, with respect to the quality of single crystals, troubles concerning generation of dislocation hardly occur. Thus, yield and productivity of silicon single crystals can be improved and marked cost reduction is made possible.

In the method for producing silicon single crystals of the present invention, the time for which silicon single crystals are produced with a single quartz crucible have only to be 100 hours or more, and a longer lifetime of the crucible is more preferred. Therefore, the upper limit of the production time is not particularly defined. However, it is preferred that the production can be continued more than 500 hours. Further, the horizontal component magnetic field strength used in the present invention should only be 500 G or more at a position where the silicon melt surface perpendicularly intersects with the side wall of the quartz crucible. Therefore, any upper limit of the horizontal component magnetic field strength may not be defined. However, 10000 G is considered a provisional upper limit for a horizontal magnetic field, and 5000 G for a cusp type magnetic field.

Now, an exemplary structure of an apparatus for pulling single crystals used for the present invention, which is based on the CZ method utilizing application of a cusp type magnetic field, will be explained by referring to Fig. 1. As shown in Fig. 1, the apparatus for pulling single crystals is constituted by a chamber 1, a quartz crucible 6 for accommodating silicon melt (melt) 4, which crucible is provided in the chamber 1, a graphite susceptor (crucible) 7 supporting the quartz crucible 6, graphite heaters 8 disposed around the graphite susceptor 7, a crucible rotating shaft 10 for rotating the quartz crucible 6 and a rotation mechanism therefor (not shown), a seed holder 12 for holding a silicon seed crystal 13, a wire 11 for pulling the seed holder 12, and a winding mechanism (not shown) for rotating or winding the wire 11. Heat insulation materials 9 are also provided around the graphite heaters 8.

Further, electromagnets 2a and 2b for an apparatus for generating a cusp type magnetic field are provided outside the chamber at the upper and lower positions in a symmetrical manner with respect to the rotation shaft 10 of the crucible as the symmetrical center. Electromagnet coils may be applied with electric currents of reverse directions to generate a cusp type magnetic field, and magnetic field strength may be controlled from a control panel 3 of the apparatus for generating magnetic field.

According to the present invention, apart from the aforementioned cusp type magnetic field, application of a horizontal magnetic field is also effective. To this end, electromagnets 2a and 2b for an apparatus for generating a magnetic field are provided in a bilaterally symmetrical manner with respect to the rotation shaft 10 of the crucible, and the magnetic field strength is controlled from a control panel 3 of the apparatus for generating magnetic field.

Hereafter, the method for growing single crystals by the aforementioned apparatus for pulling single crystals based on the CZ method in which a cusp type magnetic field is applied will be explained.

First, the electromagnets 2a and 2b for cusp type magnetic field generation apparatus are disposed at predetermined positions by an elevator mechanism (not shown). Then, a silicon polycrystal raw material of a high purity is melted in the quartz crucible 6 by heating it to a temperature higher than the melting point thereof (about 1420°C). Then, a cusp type magnetic field is applied, and Ar gas is introduced as an inert gas from an inert gas inlet pipe 15 to perform gas substitution within the chamber 1, and exhausted from an exhaust pipe 16. Subsequently, a tip end of the seed crystal 13 is brought into contact with, or immersed into the melt 4 at its approximately center portion by reeling out the wire 11. Then, the crucible rotating shaft 10 is rotated in an optional direction, and the seed crystal 13 is simultaneously pulled upwardly by winding up the wire 11 with rotating the wire to start the growing of a single crystal 5. Thereafter, an approximately columnar single crystal ingot can be obtained by appropriately controlling the pulling rate and temperature.

As explained above, if silicon single crystals are produced by the CZ method using the production method and the apparatus explained above under the appropriate conditions of the CZ method that a horizontal magnetic field or a cusp type magnetic field is applied with a suitable horizontal component magnetic field strength according to the present invention, the degradation of the quartz crucible inner surface is hardly advanced. As a result, the period for which silicon single crystals can be produced with a single quartz crucible is prolonged to 100 hours or more, and a plurality of dislocation-free single crystal ingots can be produced. Therefore, the productivity and the yield can be improved, and dislocation-free single crystal ingots can be produced in an industrial scale with a low cost.

The present invention Is not limited to the embodiments described above. The above-described embodiments are mere examples, and those having the substantially same structure as that described in the appended claims and providing the similar functions and advantages are included in the scope of the present invention.

For example, while silicon single crystal ingots having a diameter of 200 mm (8 inches) were grown in the aforementioned embodiments of the present invention, the present invention can satisfactorily be used for recently used silicon single crystals having a larger diameter of 250 mm (10 inches) to 400 mm (16 inches) or more.

## Claims

1. A method for producing silicon single crystals comprising pulling and growing single crystal ingots by the Czochralski method with applying a magnetic field, wherein a period for which silicon single crystals are produced by using a single quartz crucible is 100 hours or more.

2. The method for producing silicon single crystals according to Claim 1, wherein the applied magnetic field forms a horizontal magnetic field distribution with respect to a silicon melt in the crucible.

3. The method for producing silicon single crystals according to Claim 1, wherein the applied magnetic field forms a cusp type magnetic field distribution with respect to a silicon melt in the crucible.

4. The method for producing silicon single crystals according to any one of Claims 1-3, wherein strength of horizontal component magnetic field in the horizontal magnetic field distribution or the cusp type magnetic field distribution is 500 Gausses or more at a position where a silicon melt surface perpendicularly intersects with a side wall of the quartz crucible.

5. The method for producing silicon single crystals according to any one of Claims 1-4, wherein a pulling rate is selected to be 0.2-0.8 mm/min.
